# EUROPEAN PATENT SPECIFICATION

(11) **EP 0 666 504 B1**
(45) Date of publication and mention of the grant of the patent: **03.06.1998**
(21) Application number: 95100192.4
(22) Date of filing: 09.01.1995
(51) Int. Cl.: G03F 7/032, G03F 7/033

(54) **Aqueous photoimageable liquid emulsion, photoimageable film and process of manufacture**
Lichtempfindliche wässrige Emulsion, lichtempfindlicher Film und Verfahren zur Herstellung
Emulsion aqueuse photosensible, film photosensible et sa production

(30) Priority: 10.01.1994 US 178718
(43) Date of publication of application: 09.08.1995
(73) Proprietor: E.I. DU PONT DE NEMOURS AND COMPANY, Wilmington Delaware 19898 (US)
(72) Inventor: Kempf, Richard J., Towanda, Pennsylvania 18848 (US)
(74) Representative: von Kreisler, Alek, Dipl.-Chem.

(56) References cited:
- EP-A- 0 493 317
- EP-A- 0 546 768
- US-A- 3 979 342
- US-A- 5 045 435

## Description

### FIELD OF THE INVENTION

This invention is directed towards photoimageable film compositions that are suitabie for use in obtaining a photoimageable dry film from a stable aqueous emulsion. The photoimageable film includes but is not limited to, photoresist, solder mask, printing plate, and proofing film products. This invention is further directed towards a process for the manufacture of photoimageable dry film by coating ontp a suitable substrate a stable aqueous emulsion having a solids content corresponding to that desired in the photoimageable film and subsequently drying the coated emulsion to remove water.

### BACKGROUND OF THE INVENTION

Photoimageable materials are used to form a photoresist layer on a substrate, such as copper-clad glass epoxy, to allow subsequent selective processing of the substrate, such as selective etching or electroplating.

Photoimageable materials are also used to form a permanent solder mask layer on an imaged substrate to protect the underlying circuit lines from solder exposure during the later step of soldering in printed circuit board (PCB) manufacture. The use of photoresists and solder masks for manufacture of printed circuit boards (PCBs) is described in Photoresist - Materials and Processes, by William S. DeForest, McGraw-Hill, 1975, in Printed Circuits Handbook, edited by Clyde F. Coombs, Jr., McGraw-Hill, 1979 (2nd Edition), and in Handbook of Printed Circuit Manufacturing by Raymond H. Clark, Van Nostrand Reinhold, 1985. Photoresist and solder mask products that have substantially all of the solvent for coating removed are known as dry films. The use of photoimageable proofing films for off-press proofing in the printing industry is described in Principles of Color Proofing, by Michael H. Bruno, GAMA Communications (Salem, NH), 1986.

Aqueous liquid photoresist composition based on acrylate copolymer binders has been disclosed in U.S. Patent 5,045,435 to Armstrong World Industries. This publication is directed towards liquid photoresist compositions and teaches that at least 25% of the carboxyl-containing binder component of a composition must be neutralized to afford a stable emulsion and/or to afford sufficiently high viscosity of the resulting emulsified composition. A preferred percent neutralization is disclosed of 30-50 percent for dip-coating and 40-60 percent for screen printing. The carboxyl-containing binder has an acid number greater than 80 and a glass transition temperature greater than 60°C.

A water-borne and aqueous developable photoimageable composition comprising two types of binder components - a solution binder and an emulsion binder - has been disclosed in EPO Patent Publication 0 546 768 A1, published June 16, 1993, to Morton International, Inc. This publication teaches that stable coatable aqueous emulsions of photoimageable compositions are obtained with the use of the two binder types, emulsion and solution. The emulsion binder is dispersed in an aqueous medium as micelles with the aid of surfactant(s). The solution binder is solubilized in the aqueous medium by neutralization with ammonia or a volatile amine to the extent of at least an equal molar amount relative to the carboxylic acid functionality of the solution polymer. The emulsion binder (polymer) has an acid number between 50 and 175, while the solution binder has an acid number between 100 and 250. The emulsion binder and solution binder preferably have molecular weights (number average) of 200,000-250,000 and 100,000-200,000, respectively. Of the total amount of binder polymer, between about 10-50 weight percent is solution polymer and between about 50-90 weight percent is emulsion polymer.

A photopolymerizable composition containing a high molecular weight compound (as the binder) having a polar group and an ethylenic unsaturated compound (as the monomer) that is dispersed in water and an organic solvent is disclosed in U.S. Patent 4,542,088 to Konishiroku Photo Industry Co.. The compositions are limited to those that are dispersed in a solvent composed mainly of an organic solvent, i.e., the weight percentage of organic solvent relative to the total amount of organic solvent and water is greater than 50 percent.

Photoimageable dry film products are currently widely manufactured by coating from an organic solvent (or solvent mixture) such as methylene chloride. Due to increasing pressures from environmental considerations for reducing emissions, particularly of toxic substances, it is becoming increasingly more difficult and less feasible as well as significantly more costly to use organic solvents such as methylene chloride in coating operations for the manufacture of photoimageable materials.

There is a significant need for liquid photoimageable compositions suitable for manufacture of photoimageable dry film that minimizes the presence of organic solvent and preferably eliminates such solvent.

### SUMMARY OF INVENTION

The present invention is directed to a liquid photoimageable composition which comprises:
(a) a partially neutralized acid-containing polymer formed from a precursor polymer having an acid number from 90 to 160 prior to neutralization and wherein 1 to 15% of acid-containing groups of the precursor polymer are neutralized with base;
(b) an ethylenically unsaturated monomer;
(c) a photoinitiator or photoinitiating system, and
(d) water

wherein the liquid composition is present as a stable emulsion,
wherein the liquid composition has a Brookfield viscosity at 25 °C from 10 to 2000 mPa·s (centipoise),
wherein the liquid composition has a solids content from 25 to 60 weight percent,
with the proviso that a solution polymer, if present, is less than 5 % by weight of total polymer present in the composition, wherein the solution polymer is not the same as partially neutralized polymer (a), and
with the proviso that an amount of organic solvent, if present, is not greater than 25 % by weight on the basis of organic solvent and water.

Further, the present invention is directed to a process of coating the liquid photoimageable composition on a substrate followed by drying to yield the photoimageable dry film.

### DETAILED DESCRIPTION OF THE INVENTION

In one aspect of the present invention a stable aqueous photoimageable liquid emulsion is disclosed. The term "stable" denotes that the emulsion will maintain its homogenity for a period of at least two hours. Generally the stability will be present for a period of at least twenty-four hours and preferably for at least five days. Although the stable aqueous photoimageable liquid emulsion can be directly employed in application to a final substrate and imaged in a known manner, the emulsion is preferably utilized as a uniform coating on a temporary support with the water removed, i.e., a supported dry film is obtained prior to use on a final substrate. A high solids content of the liquid emulsion preferably minimizes the amount of necessary water which results in less water to be evaporated. However the viscosity of such a high solids content emulsion is generally high which can limit flexibility in direct application to a substrate as a uniform coating.

It is understood that the polymer particles (which serve as a binder in the final dried product) are sufficiently small to allow formation of a stable emulsion or suspension. Illustratively, if the polymer particles are too large, they are incapable of forming such an emulsion or suspension, even under optimum conditions. A proper particle size can be readily determined by one of ordinary skill in the art. For purposes of illustration, a satisfactory particle size has an average diameter between 0.05 µm (50 nm) and 1 µm (1000 nm). The preferred particle size range is 0.1 µm (100 nm) to 0.45 µm (450 nm).

For more difficult formulations to form an emulsion, one can add a surfactant to help stabilize the emulsion. Suitable surfactants are those well known in the art and especially include but are not limited to anionic and nonionic surfactants.

The emulsions prepared according to this invention have a Brookfield viscosity at 25°C ranging from 10 to 2000 mPa·s (centipoise) and a solids content from 25 to 60 weight percent. Preferably, the Brookfield viscosity at 25°C is in a range from 15 to 500 mPa·s (centipoise), and the solids content is in a range from 35 to 50 weight percent. Most preferably, the Brookfield viscosity at 25°C is in a range from 15 to 200 mPa·s (centipoise)and the solids content will range from 40 to 50 weight percent.

In a preferred mode the advantages of the present invention include one or more of the following in imaging and processing of a dry film formed from the liquid composition:
1) improved side wall geometry
2) broad development latitude
3) high resolution.

### AQUEOUS PHOTOIMAGEABLE LIQUID EMULSION

### Partially Neutralized Acid-containing Polymer

A required constituent of the stable aqueous photoimageable liquid emulsion is a partially neutralized acid-containing polymer. It is considered that the purpose of the partially neutralized polymer is to allow a stable liquid emulsion to exist without unduly limiting the viscosity of the emulsion, i.e., a high degree of neutralization outside the scope of the invention can directly result in an unduly high viscosity of the final formulation.

A precursor acid-containing polymer prior to neutralization will have an acid number from 90 to 160. Preferred acid groups are carboxylic acid groups.

It is required that the present neutralization of the precursor acid-containing polymer be not greater than 15%, i.e., not greater than 15% of the acid-containing groups are neutralized. A minimum amount of neutralization is 1%. A preferred range is 2 to 10%, and a more preferred, more narrow range is 4 to 8%.

Although higher degrees of polymer neutralization will result in stable emulsions and will, for example, allow formation of photoresists, it is considered that one or more detrimental properties are introduced solely due to the higher degree of neutralization of the acid groups of the binder polymer. An example of a detrimental property which has been found in specific instances is poor side wall geometry.

The neutralization is undertaken with a base which can be inorganic or organic. Examples of inorganic bases are sodium hydroxide, potassium hydroxide, ammonium hydroxide and ammonium carbonate. Although ammonia can be employed, it is not preferred. Examples of organic bases include amines with the formula:

NR₁R₂R₃

wherein R₁, R₂ and R₃ are independently C₁-C₂₀ substituted or unsubstituted alkyl, C₁-C₂₀ substituted or unsubstituted aralkyl, C₁-C₂₀ substituted or unsubstituted cycloalkyl, C₁-C₂₀ substituted or unsubstituted aryl or at least one of R₁, R₂ and R₃ is H or at least two of R₁, R₂ and R₃ form a ring structure selected from the group consisting of a single ring and at least two independent rings. Suitable substituents for the substituted C₁-C₂₀ alkyl groups include but are not limited to hydroxyl, alkyl acrylate and alkyl methacrylate. Examples of suitable amines are triethanolamine, diethanolamine, monoethanolamine, 2-N,N-dialkylaminoalkyl acrylate, and 2-N,N-dialkylaminoalkyl methacrylate.

Preferred bases due to ease of application have a boiling point of at least 90°C at 1.01 bar (760 mm). More preferred bases have boiling points of at least 120°C (at 1.01 bar (760 mm Hg, 1 atmosphere)) and still more preferred bases have boiling points of at least 200°C (at 1.01 bar (760 mm Hg, 1 atmosphere)).

Acid-containing polymers are well known in the prior art and are suitable in the present invention as precursor polymers provided the acid number is from 90 to 160.

The polymers present in the compositions of this invention must contain acid functionality, which is preferably achieved by incorporating one or more carboxyl-containing comonomers into the binder polymer. Preferred polymers for the instant invention also contain styrene as a comonomer. Suitable polymers for the instant invention contain 0 - 50 weight percent styrene as comonomer, have an acid number in the range 90 - 160, have a molecular weight (weight average) in the range 20,000 - 300,000, and have a glass transition temperature in the range 50 - 120°C. Preferably, the binders contain 5 - 40 % styrene as comonomer, have an acid number in the range 110 - 140, have a molecular weight (weight average) in the range 40,000 - 200,000, and have a glass transition temperature in the range 60 - 110°C. Most preferably, the polymers contain 10 - 30 % styrene as comonomer, have an acid number in the range 125-135, have a molecular weight (weight average) in the range 60,000-100,000, have a glass transition temperature in the range 70-100°C, and comprise a polymer(s) that has been polymerized using a persulfate compound (i.e., sodium, potassium, or ammonium persulfate) as the initiator for the polymerization. Use of persulfate compounds as initiators is most preferred as their use affords particularly stable polymer emulsions. While not being bound by a particular theory with regard to why use of persulfates affords stable emulsions, it is recognized that use of persulfates will introduce some charged sulfate groups onto the surface of the emulsion particles which may serve to stabilize the resulting emulsion made according to this invention by raising the electrical potential of the emulsion particles.

Preferred polymer binders are acid-containing copolymers or homopolymers comprised of at least one acid-containing monomer of structural unit: 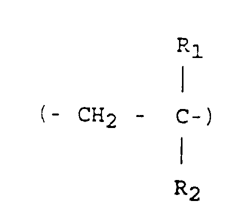 in which R₁ is H, phenyl, or alkyl; R₂ is CO₂R₃, SO₃R, or other acidic functional group; and R₃, is H or alkyl, which is unsubstituted or hydroxyl-substituted. Alkyl groups can contain one or twelve carbon atoms and preferably one to eight. Comonomers, which are suitable for forming the binder copolymer, are styrene and unsaturated carboxylic acids and their derivatives, such as (meth)acryiic acid and (meth)acrylates. Acrylic acid, methacrylic acid, methyl methacrylate, styrene, ethyl acrylate, ethyl methacrylate, butyl methacrylate, butyl acrylate, maleic anhydride, 2-hydroxyethyl methacrylate, and 2-ethylhexyl methacrylate are preferred.

Suitable binder copolymers can be formed by direct copolymerization of one or more ethylenically unsaturated dicarboxylic acid anhydrides, or the corresponding alkyl diesters, with one or more of the above comonomers. Suitable ethylenically unsaturated dicarboxylic acid anhydrides are, for example, maleic anhydride, itaconic acid anhydride and citraconic acid anhydride and alkyl diesters such as the diisobutyl ester of maleic anhydride. The copolymer binder containing acid anhydride functionality can be reacted with primary aliphatic or aromatic amines to produce acid and amide functionality.

A preferred acid-containing binder for aqueous processability in use as well as aqueous coatability in dry film manufacture is a carboxylic acid-containing copolymer, such as those disclosed in U.S. Patents 3,458,311 and 4,273,857, and which can be prepared by any of the addition polymerization techniques known to those skilled in the art such as described therein. The level of carboxylic acid groups is determined for a given composition by optimizing the amount needed for good development in aqueous alkaline developer.

When an aqueous processable photoresist or solder mask is laminated to a substrate and photoprinted, development of the photoresist or solder mask composition may require that the binder material should contain sufficient carboxylic acid groups to render the photoresist or solder mask coating composition processable in aqueous alkaline developer. The photoresist or solder mask coating layer will be removed in portions which are not exposed to radiation but will be substantially unaffected in exposed portions during development by aqueous alkaline liquids such as wholly aqueous solutions containing 1% sodium carbonate by weight at a temperature of 30°C.

### Ethylenically Unsaturated Monomer

A further required constituent of the stable aqueous photoimageable liquid emulsion is an ethylenically unsaturated monomer. Suitable monomers useful herein are well known in the prior art and typically undergo free radical initiated polymerization. The composition contains at least one or a mixture of such components. In general, preferred monomers for photopolymer applications have boiling points greater than 100°C (at 1.01 bar (760 Mm Hg, 1 atmosphere)), more preferably, greater than 150°C (at 1.01 bar (760 Mm Hg, 1 atmosphere)). Numerous unsaturated monomers polymerizable by free-radical initiated polymerization and useful in photopolymerizable compositions are known to those skilled in the art.

The monomer provides the capability of the photoresist coating composition to photopolymerize and contributes to overall properties. In order to effectively do so, the monomer should contain at least one ethylenically unsaturated group capable of undergoing polymerization on exposure to actinic radiation.

The preferred monomeric compounds are polyfunctional, but monofunctional monomers, such as (meth)acrylate esters of polycaprolactone, can also be used. Suitable monomers which can be used as the sole monomer or in combination with others include the following: diethylene glycol diacrylate, tripropylene glycol diacrylate, trimethylolpropane triacrylate, pentaerythritol triacrylate, ethoxylated trimethylolpropane tri(meth)acrylate, propoxylated trimethylolpropane tri(meth)acrylate and similar compounds as disclosed in U.S. Patent 3,380,831, triethylene glycol dimethacrylate, bisphenol A di(meth)acrylate, di-(2-methacryloxyethyl) ether of bisphenol-A, di-(3-acryloxy-2-hydroxypropyl) ether of bisphenol-A, di-(2-acryloxyethyl)ether of bisphenol-A, di-(3-methacryloxy-2-hydroxypropyl) ether of tetrachlorobisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, ethoxylated bisphenol-A di(meth)acrylate, propoxylated bisphenol A di(meth)acrylate, diacrylate of bisphenol-A diglycidyl ether and polycaprolactone diacrylate.

A particularly preferred class of comonomers is tripropylene glycol diacrylate, trimethylolpropane triacrylate, ethoxylated trimethylolpropane triacrylate, propoxylated trimethylolpropane triacrylate, ethoxylated Bisphenol A dimethacrylate, and triethylene glycol dimethacrylate.

### Photoinitiator or Photoinitiator System

The photoinitiator or photoinitiating system includes one or more compounds which directly furnish free-radicals when activated by actinic radiation. By "actinic radiation" is meant radiation which allows formation of the free-radicals necessary to initiate polymerization of the monomer. This photoinitiating system can also include a plurality of compounds, one or more of which yields the free-radicals after having been caused to do so by another compound, or sensitizer, which is activated by the radiation. The sensitizer may extend spectral response into the near ultraviolet, visible, and near infrared spectral regions. Also radiation employing a laser can be employed in specific situations.

Photoinitiators are discussed in: "Photopolymers: Radiation Curable Imaging Systems" by B. M. Monroe in Radiation Curing: Science and Technology, S. P. Pappas, Ed, Plenum, New York, 1992, pp. 399-440, and by.K. K. Dietliker, in Chemistry and Technology of UV and EB Formulation for Coatings, Inks, and Paints, "Free-Radical Polymerization", P. K. T. Oldring, Ed, SITA Technology Ltd, London, Vol. 3, 1991, pp 60-525.

The photoinitiator or photoinitiator system can be of a specific type, such as a halogenated-2,5-cyclohexadieneone, benzophenone, alkylaryl ketone or diketone type, or mixtures thereof. Any of a variety of free radical generating photoinitiators can be used to initiate polymerization in dry film photoresists and solder mask compositions manufactured according to this invention. Benzophenone derivatives such as benzophenone, bis-4,4'-dimethylaminobenzophenone (Michler's ketone), bis-4,4'-diethylaminobenzophenone (ethyl Michler's ketone), benzophenones singly or multiply substituted with other alkylamino groups, chloro, methoxy are often widely employed as photoinitiators. Preferred compounds include benzophenone, ethyl Michler's ketone, and Michler's ketone. Also substituted xanthones, thioxanthones, anthrones, and fluorenones are useful initiators, with alkyl, chloro, and alkoxy substituted thioxanthones being preferred. Substituted cyclohexadieneones such as those described in Sysak, U.S. Patent 4,341,860 can be also be used, with preferred compounds having both an alkyl and a trichloromethyl substituent in the 4 position.

The substituted 2,4,5,2',4',5'-hexaarylbiimidazole dimers (HABIs) are compounds which are often preferred in photoinitiator systems and are disclosed in: Chambers, U.S. Patent 3,479,185; Cescon, U.S. Patent 3,784,557; Dessauer, U.S. Patent 4,311,783; and Sheets, U.S. Patent 4,622,286. Preferred dimers of this class are 2-o-chlorosubstituted hexaphenylbiimidazoles in which the other positions on the phenyl radicals are unsubstituted or substituted with chloro, methyl or methoxy, such as: CDM-HABI, i.e., 2-(o-chlorophenyl)-4,5-bis(m-methoxyphenyl)-imidazole dimer; o-Cl-HABI, i.e., biimidazole, 2,2'-bis (o-chlorophenyl)-4,4'5,5'-tetraphenyl-; and TCTM-HABI, i.e., 1H-imidazole, 2,5-bis(o-chlorophenyl)-4-[3,4-dimethoxyphenyl]-, dimer, each of which is typically used with a hydrogen donor or chain transfer agent. The most preferred initiator of this class is ortho-Cl-HABI, i.e., 1,1'-biimidazole, 2,2'-bis(ortho-chlorophenyl)-4,4',5,5'-tetraphenylimidazole dimer.

Some especially preferred photoinitiators and photosensitizers are ortho-Cl-HABI, benzophenone, ethyl Michler's ketone, p-dialkylaminobenzaldehydes, p-dialkylaminobenzoate alkyl esters, cyclohexadieneones, xanthones, thioxanthones, benzil dialkyl ketals, aminoacetophenones, benzoin, benzoin dialkyl ethers, or combinations thereof where alkyl contains 1 to 4 carbon atoms.

The quantity of total photoinitiator system in a photopolymerizable composition is typically from 0.5 to 10 parts by weight relative to the total components.

### Optional Additives and Materials of Construction

In most instances in the practice of this invention and in a preferred mode, water alone is used as the dispersing medium to afford an aqueous coating emulsion. However, when needed, an organic solvent may be included in a semiaqueous emulsion formulation with the liquified ingredients to impart solubility to an otherwise difficult to dissolve ingredient or as a coalescing agent. Suitable organic solvents, if employed, include methanol, ethanol, isopropanol, n-propanol, n-butyl alcohol, propylene glycol monomethyl ether, propylene glycol monoethyl ether, propylene glycol monobutyl ether, ethylene glycol monoethyl ether, ethylene glycol monobutyl ether, propylene glycol monopropyl ether, propylene glycol t-butyl ether, and dipropylene glycol monoethyl ether, and they can be employed alone or in combination. In all cases, the amount of organic solvent relative to the total amount of organic solvent and water that is used, if employed, is less than 25 weight percent.

It is understood that the photoimageable film compositions of this invention may contain small amounts of solution polymer that may be made by solution polymerization, such as poly (vinylpyrrolidone/vinylacetate) copolymer, which functions to reduce cold flow in the photoimageable dry film during storage. However, a solution polymer, if present, will be at a concentration less than 5 percent by weight, preferably less than 3 percent by weight, and most preferably less than 2 percent by weight on the basis of total binder polymer.

Various surfactants can optionally be included in the emulsion to further stabilize the emulsion. Anionic, cationic, and nonionic surfactants can be employed; nonionic surfactants are preferred. An especially preferred class of nonionic surfactants are ethylene oxide and propylene oxide homopolymers and copolymers.

In the case of a photoimageable solder mask composition, there will be in addition to the key components listed above a crosslinking agent present to provide for curing of the imaged resist. Suitable crosslinking agents include an adduct of a polyisocyanate compound and a isocyanate group blocking agent, and formaldehyde condensation resins with melamines, ureas and benzguanidines.

Other compounds conventionally added to photoresist and solder mask photopolymer compositions may also be present in the coating to modify the physical properties of the film. Such components include: adhesion modifiers, thermal stabilizers, a printout image system comprising colorants such as dyes and pigments, viscosity control agents, coating aids, wetting agents, surfactants, release agents, fillers and crosslinking agents.

Examples of suitable printout image systems are the following: 2,2'-bis(o-chlorophenyl)-4,4',5,5'-tetraphenyl-1,1'-biimidazole and Leuco Crystal Violet (LCV); 1,2-dibromotetrachloroethane and LCV; tribromomethyl phenylsulfone (BMPS) and LCV; and 2,3- dibromo-3-phenylpropiophenone (BPP) and LCV.

Some heterocyclic compounds improve adhesion of the coating to copper-clad substrates or prevent residue formation during processing. Suitable heterocyclic components include materials such as those disclosed in Hurley et al., U.S. Patent 3,622,334, Jones, U.S. Patent 3,645,772, and Weed, U.S. Patent 4,710,262. Preferred heterocyclic components include benzotriazole, 5-chloro-benzotriazole, 1-chloro-benzotriazole, 4- and 5-carboxy-benzotriazole, 1-hydroxy-benzotriazole, 2-mercapto-benzoxazole, 1H-1,2,4-triazole-3-thiol, 5-amino-1,3,4-thiodiazole-2-thiol, and mercapto-benzimidazole.

Thermal polymerization inhibitors that can be used in the coating compositions are: p-methoxyphenol, hydroquinone, alkyl- and aryl-substituted hydroquinones and quinones, tert.-butyl catechol, 2,6-di-tert.-butyl-p-cresol, and phenothiazine. Also useful for thermal polymerization inhibitors are the nitroso compositions disclosed in U.S. 4,168,982.

Various dyes and pigments may be added to increase the visibility of the resist image. Any colorant used, however, should preferably be transparent to the actinic radiation. Representative dyes include leuco crystal violet, Victoria green dye, and Victoria blue dye.

The preferred ranges for the composition of the photoresist and solder mask are 30 to 80 parts by weight of the polymer; 10 to 50 parts by weight of monomer; and 0.5 to 10 parts by weight of the photoinitiator system.

The thickness of the photoresist or solder mask will depend on the type of printed circuit processing being done, such as etching, plating, or soldering operations.

Any of the support films known for use as such for a photoresist or solder mask coating can be used as a temporary support for coating the photoimageable material onto in the application of the present invention. The temporary support film, which preferably has a high degree of dimensional stability to temperature changes, may be chosen from a wide variety of polyamides, polyolefins, polyesters, vinyl polymers, and cellulose esters, and may have a thickness of from 6 to 200 µm A particularly suitable support film is polyethylene terephthalate having a thickness of about 25 µm

In a photoimageable film it is necessary or at least highly desirable to protect the photosensitive layer by a removable cover film in order to prevent blocking when it is stored in a roll form. The protective cover film is removed prior to lamination of the photoimageable element to a substrate.

The protective cover film may be selected from the same group of high polymer films described for the temporary support film, supra, and may have the same wide range of thicknesses; however, it is preferable to use a cover sheet that is relatively flexible under lamination conditions. A cover sheet of 25 µm thick polyethylene or polypropylene is especially suitable.

### Manufacturing Process

The process of formation of a dry film is relatively simple and direct. The stable liquid photoimageable composition of the present invention is coated onto a substrate which may be permanent or temporary. Various methods of coating can be employed which are well known in the art.

Substantially all water in the liquid composition is removed which results in a dry film. Since a relatively high solids content is present in the liquid, under preferred conditions it is considered that a relatively small amount of liquid has to be removed in forming a dry film. If an organic solvent is also employed, it is also removed in the drying process.

### DEFINITIONS

The term "solution binder" or "solution polymer" is defined to be a polymer which has been made in an organic solvent(s) from its constituent monomers.

The term "acid number" is defined to be the mg of potassium hydroxide required to neutralize the acid-functionality of 1 g of dry binder (polymer).

### GLOSSARY

### Comonomers of Polymeric Binders

MAA = methacrylic acid
EA = ethyl acrylate
MMA = methyl methacrylate
BMA = butyl methacrylate
BA = butyl acrylate
2-EHMA = 2-ethylhexyl methacrylate

| Ethylenically-unsaturated Monomers | |
|---|---|
| TMPTA = | trimethylolpropane triacrylate |
| TMPEOTA = | ethoxylated trimethylolpropane triacrylate |
| PETA = | pentaerythritol triacrylate |
| TRPGDA = | tripropylene glycol diacrylate |
| TDMA = | triethylene glycol dimethacrylate |

| Photoinitiators | |
|---|---|
| o-Cl-HABI = | biimidazole, 2,2'-bis (o-chlorophenyl)-4,4'5,5'-tetraphenyl |
| CDM-HABI = | 2-(o-chlorophenyl)-4,5-bis(m-methoxyphenyl)-imidazole dimer |

| Other | |
|---|---|
| TAOBN = | 2,3-diazabicyclo[3.2.2]non-2-ene-1,4,4-trimethyl-N,N'-dioxide |
| TMCH = | 4-methyl-4-trichloromethyl-2,5-cyclohexadiene-1-one |
| PVP K-90 = | poly(vinylpyrrolidone) having MW = 90,000. |
| TEA = | triethanolamine |

### EXAMPLES

In the following examples, all parts and percentages are by weight and all temperatures are in degrees Centigrade unless otherwise indicated. In these examples, the amounts of ingredients reported are in grams unless indicated otherwise.

### Example 1

This example illustrates the operability of the invention in the optional mode wherein an organic solvent is employed together with water as the dispersing agent.

A photopolymer emulsion was prepared having the following composition:

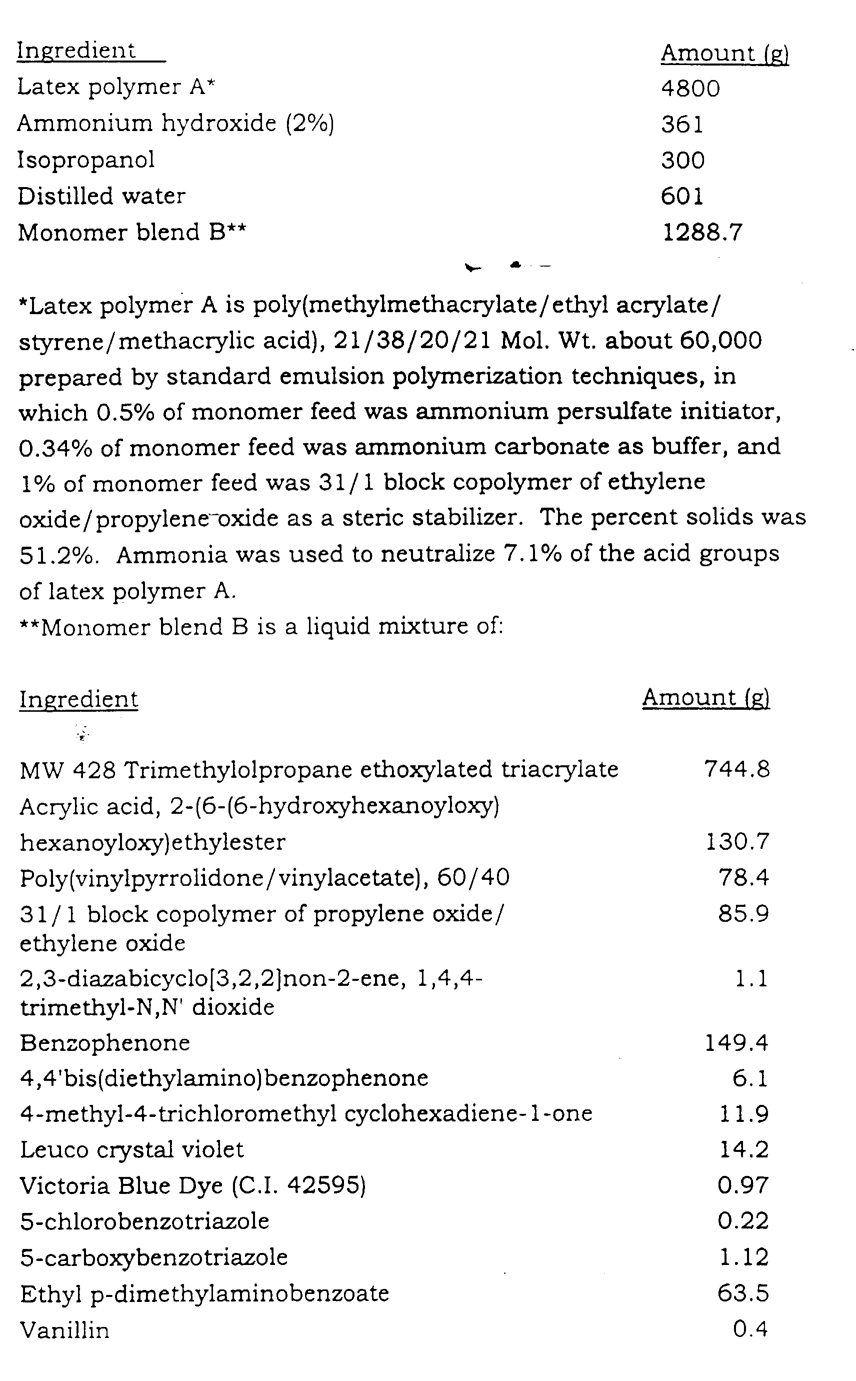

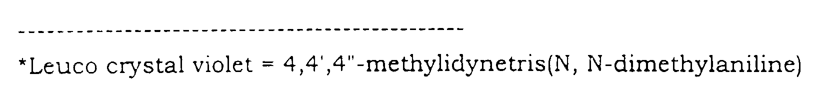

The above emulsion, which was found to be stable for a minimum of six days, was coated on a 25.4 µm (0.001 inch) thick polyethylene terephthalate support film at 3.05 meter/minute (10 feet per minute) and dried at 82 to 104 °C (180 to 220 degrees Fahrenheit) for 3 minutes to afford a high quality dry film. After drying, a 25.4 µm (0.001 inch) thick polyethylene protective sheet was laminated to the dried 38.1 µm (0.0015 inch) thick coating.

### Comparative Example 1

In this example, the performance characteristics of the film from Example 1 are compared to those of a comparable film that was solvent coated from methylene chloride.

A photopolymer solution was prepared having the following composition:

| Ingredient | Amount (g) |
|---|---|
| Methylene chloride | 3136 |
| Methanol | 237 |
| Poly(methylmethacrylate/ethyl acrylate/styrene/ methacrylic acid), 21/38/20/21 Mol. Wt. about 60,000 | 1148 |
| Monomer blend B | 602 |

The above photopolymer solution was coated on a 25.4 µm (0.001 inch) thick polyethylene terephthalate support film at 8.23 meter/minute (27 feet per minute) and dried at 82 to 104 °C (180 to 220 degrees Fahrenheit). After drying, a 25.4 µm (0.001 inch) thick polyethylene protective sheet was laminated to the dried 38.1 µm (0.0015 inch) thick coating.

The dried coated photoresist films (Example 1 and Comparative Example 1) were each laminated to FR-428.3 g (1 ounce) copper clad laminate which had been mechanically brush cleaned in a Chemcut® Model 107 scrubber using a Riston® hot roll laminator.

The unexposed resist film of Example 1 is readily soluble in 1% sodium carbonate as is apparent from its fast time to clean (TTC) of 16.3 seconds as shown in Table 1. The TTC of film coated from methylene chloride in Comparative Example 1 is 13.4 seconds. TTC was measured in 1% sodium carbonate at 29 °C (85 degrees F) using a Chemcut® Model CS-2000 aqueous developer and is defined to be the time to completely dissolve the unexposed resist film off the copper substrate. The laminated copper laminate samples were next imagewise exposed through a silver halide phototool having fine lines and spaces graduated from 0.1016mm (4 mils) wide to 0.3048 mm (12 mils) wide and a clear area on which was placed a Stouffer 41 step neutral density target using a Riston® PC-130 Printer and developed in a Chemcut® Model CS2000 developer using 1% sodium carbonate at 29°C (85 degrees F) with conveyor speed set so development of unexposed resist was complete 65% of the way through the development chamber. After imagewise exposure to 40, 70 and 100 mJ/cm² energy, the samples were developed as described above, rinsed in tap water and air dried. The photospeeds of Example 1 and Comparative Example 1 were found to be equivalent within experimental error as shown in Table 1 by the equal number of Stouffer 6√2 steps held vs. exposure energy.

**Table 1**

| Sample | TTC (s) | ⁶√2SSH 40 mJ/cm² | ⁶√2SSH 70 mJ/cm² | ⁶√2SSH 100mJ/cm² |
|---|---|---|---|---|
| Example 1 | 16.3 | 21 | 27 | 30 |
| Comparative | 13.4 | 20 | 26 | 30 |
| Example 1 | | | | |
| SSH = number of Stouffer 41 steps held. | | | | |

The imaged and developed Example 1 samples holding 21, 27 and 30 Stouffer steps, and the Comparative Example 1 samples holding 20 and 30 Stouffer steps were next electroplated with 25.4 µm (1 mil of copper followed with 12.7 µm (0.5 mil) of tin/lead using a LeaRonal Copper Bleem® (PCM+) plating bath operated a 323 A/m² (30 A/sq. ft.) and a LeaRonal Plutin® LA tin/lead plating bath operated at 161 A/m² (15 A/sq. ft. ) after receiving an acid cleaning and mild preplate etch to remove any organic surface contamination. After stripping off the exposed and polymerized resist in 1.5 % potassium hydroxide solution at 54 °C (130 degrees F), the samples were examined under a microscope and found to be free of copper or solder defects. This demonstrates the utility of the semiaqueous waterborne latex resist coating of Example 1 as a plating resist in a copper/solder plating application.

### Functionality in Acid Etching

Resist films from Example 1 and Comparative Example 1 were exposed to 70 mJ/cm² again using the fine line and space phototool which also contains a converging wedge on which 0.508 mm (20 mil) fine lines and spaces converge to a point, developed in 1% sodium carbonate using a 65% break point and etched in a cupric chloride acid etchant containing 2.5N HCl so that the exposed copper was etched 75% of the way through the etch chamber. After water rinsing all the fine lines were intact with no evidence of lifting. Lines and spaces as fine as 63.5 µm (2.5 mils) were resolved. This demonstrates the utility of the semiaqueous waterborne latex resist coating of Example 1 as an acid etch resist in an acid print and etch application.

### Example 2

In this example, the characteristics of a fully aqueous emulsion, termed the "control" emulsion and which has a low percentage neutralization value within the scope of the instant invention, were compared to four comparable emulsions designated 2A-2D, which have percent neutralization values that are much higher (>30%) and which latter values are outside the scope of the instant invention.

Photopolymer emulsions were prepared having the following compositions:

| Component | | Component Amount (g) | | | |
|---|---|---|---|---|---|
| | Control | A | B | C | D |
| Latex Polymer A of Example 1 | 422 | 422 | 422 | 211 | 211 |
| Distrilled Water | 151.7 | 35.8 | 70.8 | 150 | 345 |
| 5% NH₄OH | | | 96.2 | | |
| 2% NH₄OH | 15.3 | 131.2 | | 120.2 | 120.2 |
| Monomer Blend B of Example 1 | 111 | 111 | 111 | 55.5 | 55.5 |

| Emulsion Property | Value | | | | |
|---|---|---|---|---|---|
| % Solids | 46 | 46 | 46 | 30 | 22 |
| Percent Neutralization^{a} | 3.5 | 30 | 55 | 30 | 55 |

| | | | | | |
|---|---|---|---|---|---|
| ^{a}Percent Neutralization = (equivalents of NH₄OH per equivalent of acid functionality) x 100 | | | | | |

The control emulsion was stable over at least 7 days and had a Brookfield viscosity at 25°C of approximately 20mPa·s (centipoise) using a number 31 spindle at 30 rpm. A stable, high % solids emulsion, such as this one, is preferred for a low cost manufacturing process.

Example 2B with a high degree of neutralization (55%) was unstable at the 46% solids content. Comparative Example 2A had the appearance of "cottage cheese" before all the NH₄OH could be added. That is the latex separated into a solid resin phase and a water phase before the percent neutralization level reached the designed level of 55%.

Example 2A was also unstable at 46% solids and 30% neutralization levels, and it destabilized before all the liquid monomer blend B had been added, wherein the latex resin and the water separated into two phases. This emulsion could not be used.

Example 2C had the same composition as comparative Example 2B but the % solids was reduced from 46% to 30%. This emulsion was stable, but had an extremely high Brookfield viscosity at 25°C of 7500 mPa·s (cps) at 3 rpm using a number 31 spindle. Emulsions with such high viscosity are difficult to handle, and they must be diluted further to a final viscosity of about 20-500 mPa·s (centipoise) to be coatable in commercial production onto a continuously moving polyethylene terephthalate substrate.

Example 2D had the same composition as comparative Example 2B but % solids was reduced from 46% to 22%. Emulsion Brookfield viscosity at 25°C was 7000 mPa·s (centipoise) at 3 rpm (#31 spindle). This emulsion also had a viscosity too high to easily apply to a moving polyethylene terephthalate substrate. As the % solids decreases, it becomes less attractive to manufacture using these aqueous emulsions as the drying process becomes too slow to make the process economically feasible.

The control emulsion and emulsions 2C and 2D were manually batch coated onto a 25.4 µm (0.001 inch) thick polyethylene terephthalate support film using a doctor knife and dried at 82 to 88 °C (180 to 190 degrees F) to produce 30.5 - 38.1 µm (1.2-1.5 mil) thick dry films.

The above three dry films were each laminated to clean copper boards as described in Example 1 and placed into a 40°C/70% relative humidity oven for 5 days to simulate customer usage during the summer time and normal hold time over a long weekend break or holdup in normal processing due to processing of higher priority orders as often happens in a customer shop. After the 5 day hold, the control film and films from Examples 2C and 2D were exposed and developed as described in Example 1.

Scanning electron micrographs of the resist sidewall of the imaged "control" dry film after development indicated there was present a straight sidewall with no foot of undeveloped resist at the copper interface, which result is indicative of desirable clean, residue free development. In contrast the sidewalls from Examples 2C and 2D exhibited in each case a considerable foot of undeveloped resist at the copper interface after development, which result customers find objectionable and which is an indication of incomplete development and development residues.

After development, the "control" film and films from Examples 2C and 2D were acid etched as described in Example 1. The "control" film etched normally and afforded resolved 70 µm isolated lines and 70 µm lines/spaces. In sharp contrast, the films from Examples 2C and 2D exhibited copper residues commonly referred to as etch retardation over the entire surface. The latter boards were not usable as printed circuits.

This example illustrates the broad process of use, clean development, and high resolution achieved with dry film photoresists when a low percent neutralization value within the scope of this invention is used to stabilize a latex emulsion. Furthermore, this example illustrates that poor results are obtained with comparable compositions having high percent neutralization values that are outside the scope of this invention. This example also illustrates that stable emulsions can be prepared at significantly higher percent solids levels when low percent neutralization values are used, which equates to a lower cost manufacturing process.

### Example 3

This example illustrates the use of triethanolamine as a nonvolatile emulsion stabilizer in practicing the instant invention.

Stability to age was demonstrated in a series of emulsions prepared by adding triethanolamine (as an essentially nonvolatile stabilizer), solvent-free organic liquid (composition given below), and poly(vinylpyrrolidone) (as a coating aid) to a latex of styrene-acrylic polymer.

Successive preparations of an emulsion composition having 6.9 percent neutralization level were prepared 12 days, 7 days, and 3 hours before coating to determine the effect of aging on the coating properties of the emulsion.

The composition of the emulsion by weight was as follows:

| | (Weight %) |
|---|---|
| Latex^{a} @ 50.3% solids | 78.28 |
| TEA @ 50% in DI water | 1.88 |
| Organic liquid 100% solids | 19.69 |
| PVP K90 @ 10% in DI water | 0.1 |

| | |
|---|---|
| ^{a}This is the same latex as described in Example 1. | |

The composition of the organic liquid 100% solids was as follows:

| | (Weight %) |
|---|---|
| TMPEOTA | 61.54 |
| Acrylic acid, 2-(6-(6-hydroxyhexanoyloxy)hexanoyloxy)ethyl ester | 10.80 |
| TAOBN | 0.09 |
| Benzophenone | 12.34 |
| 2-Ethylhexyl N,N-dimethylaminobenzoate | 5.24 |
| Carboxybenzotriazole | 0.09 |
| 5-Chlorobenzotriazole | 0.02 |
| Ethyl Michler's ketone | 0.50 |
| TMCH | 0.99 |
| Victoria blue dye | 0.08 |
| Vanillin | 0.03 |
| 31/1 block copolymer of propylene oxide/ethylene oxide | 7.09 |
| Leuco crystal violet | 1.17 |

The composition of the photoimageable film was as follows:

| | |
|---|---|
| Styrene-acrylic polymer | 65.65 % |
| Triethanolamine (TEA) | 1.50 |
| Organic liquid 100% | |
| Solids | 32.80 |
| PVP K-90 | 0.025 |
| Total | 99.975 |

All emulsions prepared in multiple runs with the formulation described above were free of agglomerates. All emulsions coated satisfactorily on 25.4 µm (1 mil) Mylar® polyester film on a laboratory coater. After drying for 1 min at 88 °C (190 degrees F) coatings were laminated with polyethylene to produce a high quality roll of dry film photoresist (resist).

The resist was laminated to brush-scrubbed copper-clad epoxy board on a DuPont HRL-24 hot roll laminator, then exposed through a printed circuit artwork to 65 mJ/cm² ultraviolet energy on a DuPont PC-30 printer. Development in 1% sodium carbonate in a spray processor at 29 °C (85 degrees F) and 1.72 bar (25 psi) for 25 s gave a glossy durable resist image.

Panels electroplated through copper sulfate, then tin-lead solder and stripped in aqueous caustic (3% NaOH) at 52 °C (125 degrees F) followed by alkaline etching gave a high quality image pattern. Similarly, a panel electroplated through copper sulfate, nickel sulfamate, and gold gave a high quality image free of underplating.

Panels etched through cupric chloride at 49 °C (120 degrees F ) and stripped in hot sodium hydroxide also gave a high quality image.

Panels which were laminated and held for 10 days, then exposed, and developed as above, were free of resist residue, and etched cleanly in alkaline etchant to sharply defined circuit lines.

### Example 4

This example illustrates the use of triethanolamine as a nonvolatile emulsion stabilizer for a series of fully aqueous emulsions containing different ethylenically-unsaturated monomers.

Emulsions were prepared by the method in Example 3 except that the emulsion component of the TMPEOTA monomer was replaced by one of the monomers listed below in the percentage indicated.

| | | % Monomer |
|---|---|---|
| A. | Propoxylated neopentyl glycol diacrylate | 40 |
| B. | Aliphatic urethane diacrylate | 20 |
| C. | N,N-Dimethylaminoethyl methacrylate | 15 |
| D. | TRPGDA | 40 |
| E. | Polyethylene Glycol Dimethacrylate | 40 |
| F. | Ethoxylated Bisphenol-A dimethacrylate | 40 |
| G. | TDMA | 50 |
| X. | Control | 0 |

The composition of the organic liquid was as follows:

| Composition Organic Liquid | Weight Per Cent |
|---|---|
| Monomer | 72.30 |
| TAOBN | 0.009 |
| Benzophenone | 12.34 |
| 2-Ethylhexyl N,N-dimethylaminobenzoate | 5.24 |
| Carboxybenzotriazole | 0.09 |
| 5-Chlorobenzotriazole | 0.02 |
| Bis-4,4'-diethylaminobenzophenone | 0.50 |
| TMCH | 0.99 |
| Victoria Blue Dye (Color Index: Basic Blue 7 CI42595) | 0.08 |
| Vanillin | 0.03 |
| 31/1 block copolymer of propylene oxide/ethylene oxide | 7.09 |
| Leuco crystal violet | 1.17 |

The compositions of the emulsions prepared in this experiment were as given below.

| Composition of Emulsion | Emulsion Weight(g) | Solids Weight(g) | Dry Film Weight % |
|---|---|---|---|
| Distilled Water | 1064.0 | ---- | ---- |
| Latex (50,3% solids) | 3976.0 | 1999.93 | 65.65 |
| Triethanolamine (50% in DI water) | 45.7 | 22.85 | 1.50 |
| Organic liquid | 1000.0 | 1000.0 | 32.82 |
| PVP K90 (10% in DI water) | 7.6 | 0.76 | 0.0249 |
| Total | 6093.3 | 3023.5 | 100.0 |

The percent neutralization level of each of the emulsions in this example was 6.9%. All emulsions were stable, and coated well on a small-scale laboratory coater.

Lamination was carried out to scrubbed copper panels, followed by exposure and development at 65-75 s in 1% sodium carbonate as in Example 3, which gave the following results in comparison to the corresponding control (X) made by conventional solvent coating with methylene chloride.

| Film | Exposure Energy mJ/cm² | Step Held | Resolution Line/space mils |
|---|---|---|---|
| A | 35 | 18 | 60 |
| B | 35 | 17 | 70 |
| C | 32 | 16 | 70 |
| D | 35 | 18 | 60 |
| E | 30 | 18 | 50 |
| F | 35 | 18 | 60 |
| G | 30 | 17 | 70 |
| X | 35 | 17 | 70 |

These results demonstrate that the performance characteristics of these dry films made by aqueous coating are equivalent to that of dry film made by conventional solvent coating.

### Example 5

Emulsions were prepared as in Example 3, except that the following alternate amine compounds were evaluated as stabilizers in relation to TEA. The percent neutralization level of these emulsions was 6.9%.

### Amine Compound

A. N,N',N'',N'''-tetrakis(3-hydroxethyl)ethylenediamine
B. Tris(hydroxymethyl)aminomethane
C. N,N-Dimethylaminoethyl methacrylate
D. Triethanolamine (TEA)

Emulsions were prepared at 60% solids with 0.5 -2 % of each respective amine compound in the same manner as Example 3. Emulsions were allowed to age at room temperature and were then coated. Emulsions containing amine compounds C and D were found free of agglomerates and produced defect-free coatings at 38.1 µm (1.5 mil) thickness, whereas emulsions containing amine compounds A and B agglomerated on the agitator and vessel walls, and produced coatings of significantly lower quality.

### Example 6

The method of Example 3 was used to prepare emulsions at 40% solids except that the styrene-acrylic polymer of Example 3 was replaced in successive runs by the polymers A-C having the compositions as listed below. The percent neutralization level of each of these emulsions was 6.9%.

| Polymer | EA | MMA | S | MAA | Molecular Weight | Per Cent Solids |
|---|---|---|---|---|---|---|
| A | 35 | 24.2 | 20 | 20.8 | 60,000 | 50.3 |
| B | 37 | 16 | 27 | 20 | 69,400 | 50.0 |
| C | 35 | 44 | 0 | 21 | 55,000 | 40.0 |

wherein:
Methyl methacrylate = MMA
Ethyl acrylate = EA
Styrene = S
Methacrylic acid = MAA

Each of the emulsion samples made with the above binders was stable and afforded a high quality dry film upon aqueous coating according to this invention.

## Claims

1. A liquid photoimageable composition which comprises:
(a) a partially neutralized acid-containing polymer formed from a precursor polymer having an acid number from 90 to 160 prior to neutralization and wherein 1 to 15% of acid-containing groups of the precursor polymer are neutralized with base;
(b) an ethylenically unsaturated monomer;
(c) a photoinitiator or photoinitiating system, and
(d) water
wherein the liquid composition is present as a stable emulsion,
wherein the liquid composition has a Brookfield viscosity at 25 °C from 10 to 2000 mPa·s (centipoise),
wherein the liquid composition has a solids content from 25 to 60 weight percent,
with the proviso that a solution polymer, if present, is less than 5 % by weight of total polymer present in the composition, wherein the solution polymer is not the same as partially neutralized polymer (a), and
with the proviso that an amount of organic solvent, if present, is not greater than 25 % by weight on the basis of organic solvent and water.

2. The composition of claim 1 wherein organic solvent is absent from the composition.

3. The composition of claim 2
wherein not greater than 10% of the acid groups of the polymer are neutralized,
wherein the emulsion is stable for at least twenty four hours,
wherein the liquid composition has a Brookfield viscosity at 25 °C of from 15 to 500 mPa·s (centipoise), and
wherein the liquid composition has a solids content of from 35 to 50 weight percent.

4. A process of forming a photoimageable dry film which comprises the steps of:
(i) coating onto a substrate a liquid photoimageable composition as defined in claim 1, and
(ii) drying the coating to obtain the dry film.

5. The process of claim 4 wherein organic solvent is absent.

6. The process of claim 4 wherein organic solvent is present.

7. The process of claim 4 wherein solution polymer is absent.

## Patentansprüche

1. Flüssige, zur Bilderzeugung durch Licht geeignete Zusammensetzung, umfassend:
(a) ein partiell neutralisiertes säurehaltiges Polymer, das aus einem Vorläuferpolymer gebildet ist, das vor der Neutralisation eine Säurezahl von 90 bis 160 aufweist, wobei 1 bis 15% der säurehaltigen Gruppen des Vorläuferpolymers mit Base neutralisiert sind;
(b) ein ethylenisch ungesättigtes Monomer;
(c) einen Photoinitiator oder ein Photoinitiatorsystem; sowie
(d) Wasser;
wobei die flüssige Zusammensetzung als stabile Emulsion vorliegt,
wobei die flüssige Zusammensetzung bei 25°C eine Brookfield-Viskosität von 10 bis 2000 mPa·s (Centipoise) hat,
wobei die flüssige Zusammensetzung einen Feststoffgehalt von 25 bis 60 Gewichtsprozent hat,
mit der Maßgabe, daß ein Lösungspolymer, falls vorhanden, weniger als 5 Gew.-% des gesamten in der Zusammensetzung vorhandenen Polymers ausmacht, wobei das Lösungspolymer nicht dasselbe wie das partiell neutralisierte Polymer (a) ist, und
mit der Maßgabe, daß die Menge eines organischen Lösungsmittels, falls vorhanden, nicht größer ist als 25 Gew.-%, bezogen auf organisches Lösungsmittel und Wasser.

2. Zusammensetzung gemäß Anspruch 1, wobei kein organisches Lösungsmittel in der Zusammensetzung vorhanden ist.

3. Zusammensetzung gemäß Anspruch 2, wobei nicht mehr als 10% der Säuregruppen des Polymers neutralisiert sind
wobei die Emulsion wenigstens 24 h lang stabil ist,
wobei die flüssige Zusammensetzung bei 25°C eine Brookfield-Viskosität von 15 bis 500 mPa·s (Centipoise) hat, und
wobei die flüssige Zusammensetzung einen Feststoffgehalt von 35 bis 50 Gewichtsprozent hat.

4. Verfahren zur Bildung eines zur Bilderzeugung durch Licht geeigneten Trockenfilms, umfassend die Schritte:
(i) Auftragen einer flüssigen, zur Bilderzeugung durch Licht geeigneten Zusammensetzung gemäß Anpruch 1 auf ein Substrat sowie
(ii) Trocknen der Beschichtung, so daß man einen Trockenfilm erhält.

5. Verfahren gemäß Anspruch 4, wobei kein organisches Lösungsmittel vorhanden ist.

6. Verfahren gemäß Anspruch 4, wobei organisches Lösungsmittel vorhanden ist.

7. Verfahren gemäß Anspruch 4, wobei kein Lösungspolymer vorhanden ist.

## Revendications

1. Composition liquide photosensible qui comprend :
(a) un polymère partiellement neutralisé contenant des radicaux acides formé à partir d'un polymère précurseur ayant un indice d'acide de 90 à 160 avant neutralisation et dans lequel une proportion de 1 à 15% des groupes contenant des radicaux acides du polymère précurseur est neutralisée par une base,
(b) un monomère à insaturation éthylénique,
(c) un photo-initiateur ou système de photo-initiation, et
(d) de l'eau,
dans laquelle la composition liquide est présente sous la forme d'une émulsion stable,
dans laquelle la composition liquide a une viscosité Brookfield à 25°C de 10 à 2000 mPa.s (centipoises),
dans laquelle la composition liquide a une teneur en solides de 25 à 60% en poids,
à condition qu'un polymère en solution, s'il est présent, le soit en quantité inférieure à 5% en poids du polymère total présent dans la composition, le polymère en solution n'étant pas le même que le polymère partiellement neutralisé (a), et
à condition qu'une quantité de solvant organique, s'il est présent, ne soit pas supérieure à 25% en poids par rapport au solvant organique et à l'eau.

2. Composition selon la revendication 1, dans laquelle il n'y a pas de solvant organique dans la composition.

3. Composition selon la revendication 2,
dans laquelle une proportion non supérieure à 10% des groupes radicaux acides du polymère est neutralisée,
dans laquelle l'émulsion est stable pendant au moins 24 heures,
dans laquelle la composition liquide a une viscosité Brookfield à 25°C de 15 à 500 mPa.s (centipoises), et
dans laquelle la composition liquide a une teneur en solides de 35 à 50% en poids.

4. Procédé de formation d'un film sec photosensible qui comprend les étapes consistant :
(i) à appliquer sur un substrat une composition photosensible liquide telle que définie dans la revendication 1, et
(ii) à sécher le revêtement pour obtenir le film sec.

5. Procédé selon la revendication 4, dans lequel il n'y a pas de solvant organique.

6. Procédé selon la revendication 4, dans lequel il y a un solvant organique.

7. Procédé selon la revendication 4, dans lequel il n'y a pas de polymère en solution.
